# EUROPEAN PATENT SPECIFICATION

(11) **EP 3 269 491 B1**
(45) Date of publication and mention of the grant of the patent: **27.11.2019**
(21) Application number: 16761601.0
(22) Date of filing: 02.03.2016
(51) Int. Cl.: B23K 20/00, B23K 1/00, H01L 23/40, B23K 101/40, H01L 23/373, C04B 37/02, H01L 21/48, B23K 11/20, H01L 23/473, H01L 33/64, B23K 103/10, B23K 103/12, B23K 103/18

(54) **MANUFACTURING METHOD FOR JUNCTION, MANUFACTURING METHOD FOR SUBSTRATE FOR POWER MODULE WITH HEAT SINK, AND MANUFACTURING METHOD FOR HEAT SINK**
HERSTELLUNGSVERFAHREN FÜR EINE VERBINDUNG, HERSTELLUNGSVERFAHREN FÜR EIN SUBSTRAT FÜR EIN LEISTUNGSMODUL MIT WÄRMESENKE UND HERSTELLUNGSVERFAHREN FÜR EINE WÄRMESENKE
PROCÉDÉ DE FABRICATION POUR JONCTION, PROCÉDÉ DE FABRICATION POUR SUBSTRAT POUR MODULE DE PUISSANCE AVEC DISSIPATEUR DE CHALEUR, ET PROCÉDÉ DE FABRICATION POUR DISSIPATEUR DE CHALEUR

(30) Priority: 11.03.2015 JP 2015048151; 12.02.2016 JP 2016025164
(43) Date of publication of application: 17.01.2018
(73) Proprietor: Mitsubishi Materials Corporation, Chiyoda-ku Tokyo 100-8117 (JP)
(72) Inventor: TERASAKI Nobuyuki, Kitamoto-shi Saitama 364-0022 (JP); NAGATOMO Yoshiyuki, Kitamoto-shi Saitama 364-0022 (JP)
(74) Representative: Hoffmann Eitle
(86) International application number: PCT/JP2016/056409
(87) International publication number: WO 2016/143631

(56) References cited:
- EP-A1- 2 833 398
- WO-A1-2014/184880
- JP-A- 2013 111 606
- JP-A- 2014 097 526
- JP-A- 2014 177 031

## Description

### TECHNICAL FIELD

The present invention relates to a method of manufacturing a bonded body that is constituted by bonding an aluminum member formed from an aluminum alloy that contains a relatively large amount of Si and a copper member that is formed from copper or a copper alloy, a method of manufacturing a power module substrate with a heat sink in which the heat sink is bonded to a power module substrate in which a circuit layer is formed on one surface of an insulating layer, and a method of manufacturing a heat sink in which a copper member layer is formed in the heat sink main body.

### BACKGROUND ART

A semiconductor device such as an LED and a power module are provided with a structure in which a semiconductor element is bonded onto a circuit layer formed from a conductive material.

In a large-power control power semiconductor element that is used to control wind power generation, an electric vehicle, a hybrid car, and the like, the amount of heat generation is large. According to this, as a substrate on which the power semiconductor element is mounted, for example, a power module substrate including a ceramic substrate formed from aluminum nitride (AlN), alumina (Al₂O₃), and the like, and a circuit layer formed by bonding a metal plate with excellent conductivity on one surface of the ceramic substrate has been widely used in the related art. Furthermore, as the power module substrate, a power module substrate in which a metal layer is formed on the other surface of the ceramic substrate is also provided.

For example, a power module disclosed in PTL 1 has a structure including a power module substrate in which a circuit layer and a metal layer which are formed from Al are respectively formed on one surface and the other surface of a ceramic substrate, and a semiconductor element that is bonded onto the circuit layer through a solder material.

In addition, a heat sink is bonded to a lower side of the power module substrate to radiate heat, which is transferred from the semiconductor element to the power module substrate side, to an outer side through the heat sink.

However, as is the case with the power module described in PTL 1, in a case where the circuit layer and the metal layer are constituted by Al, an oxide film of Al is formed on a surface, and thus it is difficult to bond the semiconductor element or the heat sink onto the surface with the solder material.

Accordingly, for example, as disclosed in PTL 2, after a Ni plating film is formed on the surface of the circuit layer and the metal layer through electroless plating and the like, the semiconductor element or the heat sink is soldered.

In addition, PTL 3 suggests a technology of bonding the circuit layer and the semiconductor element, and the metal layer and the heat sink, respectively, by using silver oxide paste containing a reducing agent including silver oxide particles and an organic material as an alternative of the solder material.

However, as described in PTL 2, in the power module substrate in which the Ni plating film is formed on the surface of the circuit layer and the metal layer, during bonding of the semiconductor element and the heat sink, a surface of the Ni plating film deteriorates due to oxidation and the like, and thus there is a concern that bonding reliability of the semiconductor element and the heat sink which are bonded through the solder material deteriorates. Here, when bonding between the heat sink and the metal layer is not sufficient, there is a concern that heat resistance increases, and thus heat dissipation characteristics deteriorate. In addition, in a Ni plating step, a masking process may be performed in order to prevent problems such as electrolytic corrosion due to formation of the Ni plating in an unnecessary region occurring. As described above, in a case of performing a plating process after performing the masking process, a great deal of labor is necessary in the step of forming the Ni plating film on the surface of the circuit layer and the surface of the metal layer, and thus there is a problem in that the manufacturing cost of the power module greatly increases.

In addition, as described in PTL 3, in a case of respectively bonding the circuit layer and the semiconductor element, and the metal layer and the heat sink by using the silver oxide paste, bondability between Al and a baked body of the silver oxide paste is poor, and thus it is necessary to form a Ag underlying layer on the surface of the circuit layer and the surface of the metal layer in advance. In a case of forming the Ag underlying layer through plating, there is a problem in that a great deal of labor is necessary similar to Ni plating.

Accordingly, PTL 4 suggests a power module substrate in which the circuit layer and the metal layer are set to have a laminated structure of an Al layer and a Cu layer. In the power module substrate, the Cu layer is disposed on the surface of the circuit layer and the metal layer, and thus it is possible to bond the semiconductor element and the heat sink by using a solder material in a satisfactory manner. As a result, heat resistance in a laminating direction decreases, and thus it is possible to transfer heat generated from the semiconductor element to the heat sink side in a satisfactory manner.

In addition, PTL 5 suggests a power module substrate with a heat sink in which one of the metal layer and the heat sink is constituted by aluminum or an aluminum alloy, the other side is constituted by copper or a copper alloy, and the metal layer and the heat sink are subjected to solid-phase diffusion bonding. In the power module substrate with a heat sink, the metal layer and the heat sink are subjected to solid-phase diffusion bonding, and thus heat resistance is small, and heat dissipation characteristics are excellent.

In addition, PTL 6 suggests a power module substrate with a heatsink bonded to the power module substrate, having a circuit layer formed on a surface of an insulation layer and a semiconductor device bonded to the power module substrate.

### CITATION LIST

### PATENT LITERATURE

[PTL 1] Japanese Patent Publication No. 3171234
[PTL 2] Japanese Unexamined Patent Application, First Publication No. 2004-172378
[PTL 3] Japanese Unexamined Patent Application, First Publication No. 2008-208442
[PTL 4] Japanese Unexamined Patent Application, First Publication No. 2014-160799
[PTL 5] Japanese Unexamined Patent Application, First Publication No. 2014-099596
[PTL 6] EP2833398 A1

### DISCLOSURE OF INVENTION

### TECHNICAL PROBLEM

However, in a heat sink having a complicated structure in which a flow passage of a cooling medium and the like are formed on an inner side, the heat sink may be manufactured by using a casted aluminum alloy that contains a relatively large amount of Si.

Here, in a case of subjecting the aluminum member formed from a casted aluminum alloy that contains a relatively large amount of Si, and the copper member formed from copper or a copper alloy to the solid-phase diffusion bonding as described in PTL 5, it is confirmed that numerous Kirkendall voids, which occur due to unbalance of mutual diffusion, occur in the vicinity of a bonding interface. When the Kirkendall voids exist between the power module substrate and the heat sink, heat resistance increases, and thus there is a problem in that heat dissipation characteristics deteriorate.

The invention has been made in consideration of the above-described circumstances, and an object thereof is to provide a method of manufacturing a bonded body which is capable of suppressing occurrence of a Kirkendall void at a bonding interface even in a case where an aluminum member formed from an aluminum alloy that contains a relatively large amount of Si and a copper member formed from copper or a copper alloy are subjected to solid-phase diffusion bonding, a method of manufacturing a power module substrate with a heat sink, and a method of manufacturing a heat sink.

### SOLUTION TO PROBLEM

The present inventors have made a thorough investigation, and as a result, they obtained the following finding. It is proved that when Si and Cu come into contact with each other, diffusion of Cu is promoted when considering that Si has a melting point higher than that of Cu, and a diffusion velocity of Cu in Si is fast. According to this, when a coarse Si phase exists in an aluminum member formed from an aluminum alloy that contains a relatively large amount of Si, the Si phase and Cu in a copper member come into contact with each other at a bonding interface between the aluminum member and the copper member, and diffusion of Cu is promoted. As a result, numerous Kirkendall voids occur.

The invention has been made on the basis of the above-described finding. According to an aspect of the invention, a method is provided for manufacturing a bonded body in which a copper member formed from copper or a copper alloy, and an aluminum member formed from an aluminum alloy in which a Si concentration is set in a range of 1 mass% to 25 mass% are bonded to each other. In the aluminum member before the bonding, D90 of an equivalent circle diameter of a Si phase at a bonding surface with the copper member is set in a range of 1 µm to 8 µm, and the aluminum member and the copper member are subjected to solid-phase diffusion bonding.

According to the method of manufacturing a bonded body which has the above-described configuration, at the bonding surface with the copper member in the aluminum member constituted by the aluminum alloy in which the Si concentration is set in a range of 1 mass% to 25 mass%, D90 of the equivalent circle diameter of the Si phase dispersed in a parent phase is set in a range of 1 µm to 8 µm. Accordingly, the Si phase at the bonding surface, at which the Si phase comes into contact with the copper member, is sufficiently made to be fine, and diffusion of Cu in the copper member is not promoted. As a result, it is possible to suppress occurrence of a Kirkendall void at a bonding interface.

Here, in the method of manufacturing a bonded body of the invention, it is preferable that the aluminum member and the copper member be laminated and electrically heated while being pressurized in a laminating direction to subject the aluminum member and the copper member to the solid-phase diffusion bonding.

In this case, the aluminum member and the copper member are electrically heated while being pressurized in the laminating direction, it is possible to make a temperature rising rate fast, and thus it is possible to perform the solid-phase diffusion bonding in a relatively short time. As a result, for example, even when bonding is performed in the atmosphere, an influence of oxidation on the bonding surface is small, and thus it is possible to bond the aluminum member and the copper member in a satisfactory manner.

According to another aspect of the invention, a method is provided for manufacturing a power module substrate with a heat sink including an insulating layer, a circuit layer that is formed on one surface of the insulating layer, a metal layer that is formed on the other surface of the insulating layer, and a heat sink that is disposed on a surface of the metal layer which is opposite to the insulating layer. A bonding surface with the heat sink in the metal layer is constituted by copper or a copper alloy, and a bonding surface with the metal layer in the heat sink is constituted by an aluminum alloy in which a Si concentration is set in a range of 1 mass% to 25 mass%. In the heat sink before the bonding, D90 of an equivalent circle diameter of a Si phase at the bonding surface with the metal layer is set in a range of 1 µm to 8 µm, and the heat sink and the metal layer are subjected to solid-phase diffusion bonding.

According to the method of manufacturing a power module substrate with a heat sink which has the above-described configuration, at the bonding surface with the metal layer that is formed from copper or a copper alloy in the heat sink that is constituted by an aluminum alloy in which the Si concentration is set in the range of 1 mass% to 25 mass%, D90 of the equivalent circle diameter of the Si phase dispersed in a parent phase is set in a range of 1 µm to 8 µm. Accordingly, the Si phase at the bonding surface, at which the Si phase comes into contact with the metal layer, is sufficiently made to be fine, and diffusion of Cu in the metal layer is not promoted. Accordingly, it is possible to suppress occurrence of a Kirkendall void at a bonding interface. As a result, it is possible to provide a power module substrate with a heat sink in which heat resistance is small, and heat dissipation is excellent.

In addition, in the method of manufacturing a power module substrate with a heat sink according to the aspect of the invention, the heat sink is constituted by an aluminum alloy in which the Si concentration is set in the range of 1 mass% to 25 mass%, and thus it is possible to construct the heat sink having a complicated structure provided with a flow passage and the like. As a result, it is possible to improve heat dissipation characteristics of the heat sink.

Here, in the method of manufacturing a power module substrate with a heat sink according to the aspect of the invention, it is preferable that the heat sink and the metal layer be laminated and electrically heated while being pressurized in a laminating direction to subject the heat sink and the metal layer to the solid-phase diffusion bonding.

In this case, the heat sink and the metal layer are electrically heated while being pressurized in the laminating direction, it is possible to make a temperature rising rate fast, and thus it is possible to perform the solid-phase diffusion bonding in a relatively short time. As a result, for example, even when bonding is performed in the atmosphere, an influence of oxidation on the bonding surface is small, and thus it is possible to bond the heat sink and the metal layer in a satisfactory manner.

According to still another aspect of the invention, a method is provided for manufacturing a heat sink including a heat sink main body, and a copper member layer formed from copper or a copper alloy. A bonding surface with the copper member layer in the heat sink main body is constituted by an aluminum alloy in which a Si concentration is set in a range of 1 mass% to 25 mass%. In the heat sink main body before the bonding, D90 of an equivalent circle diameter of a Si phase at a bonding surface with the copper member layer is set in a range of 1 µm to 8 µm, and the heat sink main body and the copper member layer are subjected to solid-phase diffusion bonding.

According to the method of manufacturing a heat sink which has the above-described configuration, at the bonding surface with the copper member layer that is formed from copper or a copper alloy in the heat sink main body that is constituted by an aluminum alloy in which the Si concentration is set in the range of 1 mass% to 25 mass%, D90 of the equivalent circle diameter of the Si phase dispersed in a parent phase is set in a range of 1 µm to 8 µm. Accordingly, the Si phase at the bonding surface, at which the Si phase comes into contact with the copper member layer, is sufficiently made to be fine, and diffusion of Cu in the copper member layer is not promoted. Accordingly, it is possible to suppress occurrence of a Kirkendall void at a bonding interface. As a result, it is possible to provide a heat sink in which heat resistance is small, and heat dissipation is excellent.

In addition, the heat sink main body is constituted by an aluminum alloy in which the Si concentration is set in a range of 1 mass% to 25 mass%, and thus it is possible to construct a heat sink main body having a complicated structure provided with a flow passage and the like. In addition, the copper member layer, which is formed from copper or a copper alloy, is formed on the heat sink main body, and thus the heat sink and another member can be bonded to each other through solder and the like in a satisfactory manner. In addition, it is possible to make heat spread in a plane direction by the copper member layer, and thus it is possible to greatly improve heat dissipation characteristics.

Here, in the method of manufacturing a heat sink of the invention, it is preferable that the heat sink main body and the copper member layer be laminated and electrically heated while being pressurized in a laminating direction to subject the heat sink main body and the copper member layer to the solid-phase diffusion bonding.

In this case, the heat sink main body and the copper member layer are electrically heated while being pressurized in the laminating direction, it is possible to make a temperature rising rate fast, and thus it is possible to perform the solid-phase diffusion bonding in a relatively short time. As a result, for example, even when bonding is performed in the atmosphere, an influence of oxidation on the bonding surface is small, and thus it is possible to bond the heat sink main body and the copper member layer in a satisfactory manner.

### ADVANTAGEOUS EFFECTS OF INVENTION

According to the invention, it is possible to provide a method of manufacturing a bonded body which is capable of suppressing occurrence of a Kirkendall void at a bonding interface even in a case where an aluminum member formed from an aluminum alloy that contains a relatively large amount of Si and a copper member formed from copper or a copper alloy are subjected to solid-phase diffusion bonding, a method of manufacturing a power module substrate with a heat sink, and a method of manufacturing a heat sink.

### BRIEF DESCRIPTION OF DRAWINGS

FIG. 1 is a schematic view illustrating a power module including a power module substrate with a heat sink according to a first embodiment of the invention.
FIG. 2 is a flowchart illustrating a method of manufacturing the power module substrate with a heat sink according to the first embodiment, and a method of manufacturing a power module including the power module substrate with a heat sink according to the first embodiment.
FIG. 3 is a schematic view illustrating a method of manufacturing the power module substrate according to the first embodiment, and a method of manufacturing the power module substrate with a heat sink according to the first embodiment.
FIG. 4 is a photograph obtained by observing a structure of a bonding surface with a copper member in a heat sink before bonding in the method of manufacturing the power module substrate according to the first embodiment.
FIG. 5 is a schematic view illustrating a heat sink according to a second embodiment of the invention.
FIG. 6 is a flowchart illustrating a method of manufacturing the heat sink according to the second embodiment.
FIG. 7 is a schematic view illustrating the method of manufacturing the heat sink according to the second embodiment.
FIG. 8 is a schematic view of a power module including a power module substrate with a heat sink according to another embodiment of the invention.
FIG. 9 is a schematic view illustrating a situation in which solid-phase diffusion bonding is performed by an electrical heating method.
FIG. 10 is a view illustrating a sequence of measuring an equivalent circle diameter of a Si phase at a bonding surface in Example 2.
FIG. 11 is a view illustrating a sequence of measuring the equivalent circle diameter of the Si phase at the bonding surface in Comparative Example 2.

### BEST MODE FOR CARRYING OUT THE INVENTION

### (First Embodiment)

Hereinafter, description will be given of embodiments of the invention with reference to the accompanying drawings.

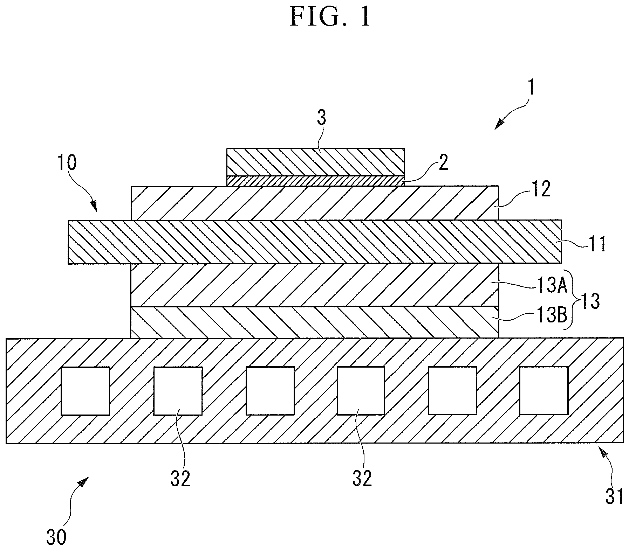

FIG. 1 illustrates a power module 1 using a power module substrate with a heat sink 30 according to a first embodiment of the invention.

The power module 1 includes the power module substrate with a heat sink 30, and a semiconductor element 3 that is bonded to one surface (an upper surface in FIG. 1) of the power module substrate with a heat sink 30 through a solder layer 2.

The power module substrate with a heat sink 30 includes a power module substrate 10 and a heat sink 31 that is bonded to the power module substrate 10.

The power module substrate 10 includes a ceramic substrate 11 that constitutes an insulating layer, a circuit layer 12 that is arranged on one surface (an upper surface in FIG. 1) of the ceramic substrate 11, and a metal layer 13 that is arranged on the other surface of the ceramic substrate 11.

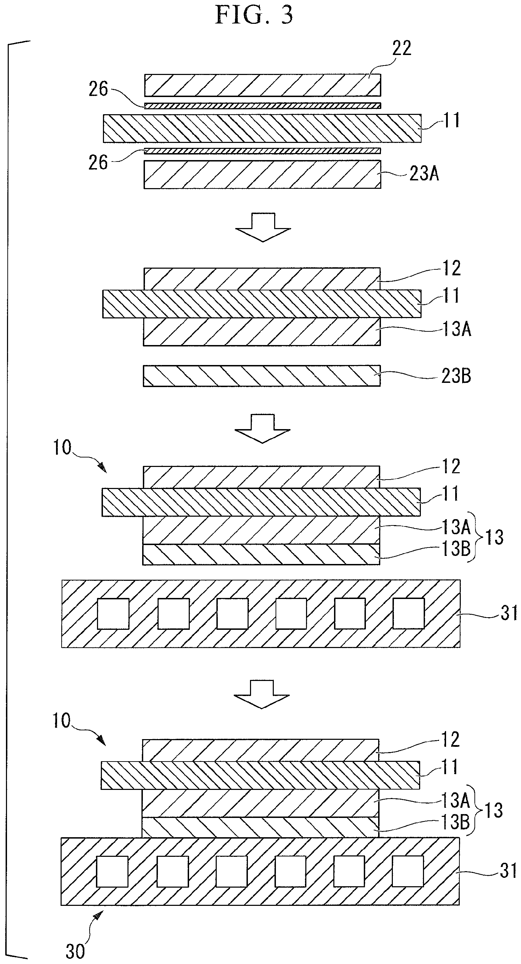

As illustrated in FIG. 3, the circuit layer 12 is formed by bonding an aluminum plate 22, which is formed from aluminum or an aluminum alloy, onto one surface of the ceramic substrate 11. In this embodiment, the circuit layer 12 is formed by bonding a rolled plate (aluminum plate 22) of aluminum (2N aluminum) having the purity of 99 mass% or greater to the ceramic substrate 11. Furthermore, the thickness of the aluminum plate 22, which becomes the circuit layer 12, is set in a range of 0.1 mm to 1.0 mm, and is set to 0.6 mm in this embodiment.

As illustrated in FIG. 1, the metal layer 13 includes an Al layer 13A that is arranged on the other surface of the ceramic substrate 11, and a Cu layer 13B that is laminated on a surface of the Al layer 13A which is opposite to a surface to which the ceramic substrate 11 is bonded.

As illustrated in FIG. 3, the Al layer 13A is formed by bonding an aluminum plate 23A, which is formed from aluminum or an aluminum alloy, onto the other surface of the ceramic substrate 11. In this embodiment, the Al layer 13A is formed by bonding a rolled plate (aluminum plate 23A) of aluminum (2N aluminum) having the purity of 99 mass% or greater to the ceramic substrate 11. The thickness of the aluminum plate 23A that is bonded to the ceramic substrate 11 is set in a range of 0.1 mm to 1.0 mm, and is set to 0.6 mm in this embodiment.

The Cu layer 13B is formed by bonding a copper plate 23B, which is formed from copper or a copper alloy, to the other surface of the Al layer 13A. In this embodiment, the Cu layer 13B is formed by bonding a rolled plate (copper plate 23B) of oxygen-free copper to the other surface of the Al layer 13A. The thickness of the copper layer 13B is set in a range of 0.1 mm to 6 mm, and is set to 1 mm in this embodiment.

The heat sink 31 is configured to radiate heat on a power module substrate 10 side. In this embodiment, as illustrated in FIG. 1, the heat sink 31 is provided with a flow passage 32 through which a cooling medium flows.

The heat sink 31 is constituted by an aluminum alloy in which a Si concentration is set in a range of 1 mass% to 25 mass%. Specifically, the heat sink 31 is constituted by ADC12 that is a die-casting aluminum alloy defined in JIS H 2118:2006. Furthermore, ADC12 is an aluminum alloy that contains Cu in a range of 1.5 to 3.5 mass%, and Si in a range of 9.6 to 12.0 mass%. It is preferable that the Si concentration of the aluminum alloy be set to a range of 10.5 mass% to 12.0 mass%, but there is no limitation to the range.

Here, the heat sink 31 and the metal layer 13 (Cu layer 13B) are subjected to solid-phase diffusion bonding.

An intermetallic compound layer is formed at a bonding interface between the metal layer 13 (Cu layer 13B) and the heat sink 31. The intermetallic compound layer is formed through mutual diffusion of Al atoms of the heat sink 31 and Cu atoms of the Cu layer 13B. The intermetallic compound layer has a concentration gradient in which the concentration of Al atoms further decreases, and the concentration of Cu atoms further increases as it goes toward the Cu layer 13B from the heat sink 31.

The intermetallic compound layer is constituted by an intermetallic compound composed of Cu and Al. In this embodiment, the intermetallic compound layer has a structure in which a plurality of the intermetallic compounds are laminated along the bonding interface. Here, the thickness of the intermetallic compound layer is set in a range of 1 µm to 80 µm, and preferably in a range of 5 µm to 80 µm.

In addition, in this embodiment, the intermetallic compound layer has a structure in which three kinds of intermetallic compounds are laminated. In the order from the heat sink 31 side toward the Cu layer 13B side, a 0-phase and a η₂-phase are laminated along the bonding interface between the heat sink 31 and the Cu layer 13B, and at least one phase among a ζ₂-phase, a δ-phase, and a γ₂-phase is laminated.

In addition, at the bonding interface between the intermetallic compound layer and the Cu layer 13B, oxides are dispersed in a layer shape along the bonding interface. Furthermore, in this embodiment, the oxides are composed of aluminum oxides such as alumina (Al₂O₃). Furthermore, the oxides are dispersed at the interface between the intermetallic compound layer and the Cu layer 13B in a disconnected state, and a region in which the intermetallic compound layer and the Cu layer 13B are in direct contact with each other also exists. In addition, the oxides may be dispersed at the inside of the θ-phase, the η₂-phase, and at least one phase among the ζ₂-phase, the δ-phase, and the γ₂-phase in a layer shape.

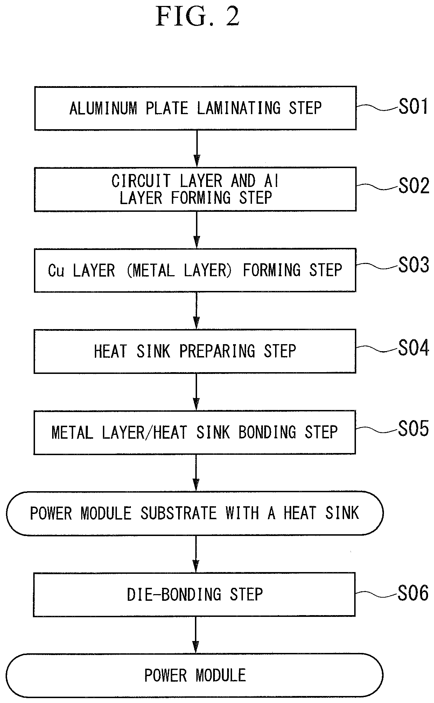

Next, description will be given of a method of manufacturing the power module substrate with a heat sink 30 according to this embodiment with reference to FIG. 2 to FIG. 4.

### (Aluminum Plate Laminating Step S01)

First, as illustrated in FIG. 3, the aluminum plate 22, which becomes the circuit layer 12, is laminated on one surface of the ceramic substrate 11 through Al-Si-based solder material foil 26.

In addition, the aluminum plate 23A, which becomes the Al layer 13A, is laminated on the other surface of the ceramic substrate 11 through Al-Si-based solder material foil 26. Furthermore, in this embodiment, as the Al-Si-based solder material foil 26, Al-6 mass% Si alloy foil having a thickness of 15 µm is used.

### (Circuit Layer and Al Layer Forming Step S02)

In addition, the resultant laminated body is put in a vacuum heating furnace and is heated therein in a pressurized state (pressure is set to 1 to 35 kgf/cm² (0.10 to 3.43 MPa)) in a laminating direction to bond the aluminum plate 22 and the ceramic substrate 11, thereby forming the circuit layer 12. In addition, the ceramic substrate 11 and the aluminum plate 23A are bonded to form the Al layer 13A.

Here, it is preferable that the pressure inside the vacuum heating furnace be set in a range of 10⁻⁶ Pa to 10⁻³ Pa, a heating temperature be set to 600°C to 643°C, and retention time be set in a range of 30 minutes to 180 minutes.

### (Cu Layer (Metal Layer) Forming Step S03)

Next, the copper plate 23B, which becomes the Cu layer 13B, is laminated on the other surface side of the Al layer 13A.

In addition, the resultant laminated body is put in a vacuum heating furnace and is heated therein in a pressurized state (pressure is set to 3 to 35 kgf/cm² (0.29 to 3.43 MPa)) in a laminating direction to subject the Al layer 13A and the copper plate 23B to solid-phase diffusion bonding, thereby forming the metal layer 13.

Here, it is preferable that the pressure inside the vacuum heating furnace be set in a range of 10⁻⁶ Pa to 10⁻³ Pa, a heating temperature be set to 400°C to 548°C, and retention time be set in a range of 5 minutes to 240 minutes.

Furthermore, in respective bonding surfaces, which are subjected to the solid-phase diffusion bonding, of the Al layer 13A and the copper plate 23B, scratches on the bonding surface are removed in advance and thus the bonding surfaces are made to be smooth.

### (Heat Sink Preparing Step S04)

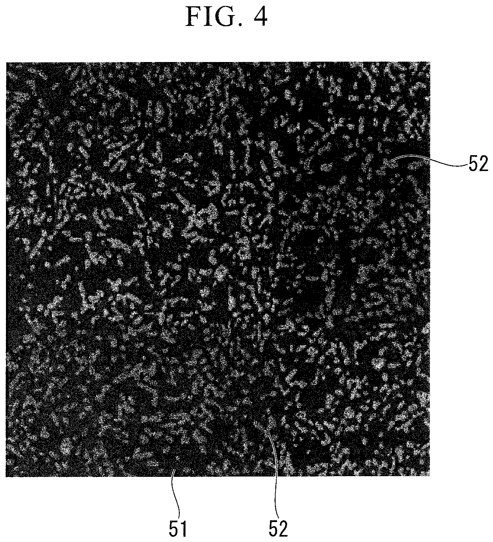

Next, the heat sink 31 to be bonded is prepared. At this time, as illustrated in FIG. 4, at a bonding surface, which is bonded to the metal layer 13 (Cu layer 13B), of the heat sink 31, D90 of an equivalent circle diameter of a Si phase 52 dispersed in a parent phase 51 is set in a range of 1 µm to 8 µm.

Here, during casting of the heat sink 31, it is possible to control a size and a shape of the Si phase 52 at the bonding surface by adjusting a cooling rate at least in the vicinity of the bonding surface of the heat sink 31. In this case, for example, a mold temperature in the casting may be set to 230°C or lower, and preferably 210°C or lower. The lower limit of the mold temperature during the casting may be 170°C, but there is no limitation thereto.

Alternatively, it is possible to control the size and the shape of the Si phase 52 at the bonding surface by melting at least the vicinity of the bonding surface of the heat sink 31 and rapidly cooling the vicinity.

### (Metal Layer/Heat Sink Bonding Step S05)

Next, the metal layer 13 (Cu layer 13B) and the heat sink 31 are laminated, and the resultant laminated body is put in a vacuum heating furnace and is heated therein in a pressurized state (pressure is set to 5 to 35 kgf/cm² (0.49 to 3.43 MPa)) in a laminating direction to subject the metal layer 13 (Cu layer 13B) and the heat sink 31 to solid-phase diffusion bonding. Furthermore, in respective bonding surfaces, which are subjected to the solid-phase diffusion bonding, of the metal layer 13 (Cu layer 13B) and the heat sink 31, scratches on the bonding surface are removed in advance and thus the bonding surfaces are made to be smooth.

Here, it is preferable that the pressure inside the vacuum heating furnace be set in a range of 10⁻⁶ Pa to 10⁻³ Pa, a heating temperature be set to 400°C to 520°C, and retention time be set in a range of 0.5 hours to 3 hours.

In this manner, the power module substrate with a heat sink 30 according to this embodiment is manufactured.

### (Die-Bonding Step S06)

Here, the semiconductor element 3 is laminated on one surface (front surface) of the circuit layer 12 through a solder material, and the resultant laminated body is subjected to solder bonding in a reducing furnace.

In this manner, the power module 1 according to this embodiment is manufactured.

According to the method of manufacturing the power module substrate with a heat sink 30, which has the above-described configuration, according to this embodiment, the heat sink 31 constituted by an aluminum alloy, in which the Si concentration is set in a range of 1 mass% to 25 mass%, is used, and the method includes the heat sink preparing step S04 of preparing the heat sink 31 in which at the bonding surface with the metal layer 13 (Cu layer 13B), D90 of the equivalent circle diameter of the Si phase 52 dispersed in a parent phase 51 is set in a range of 1 µm to 8 µm. Accordingly, the Si phase 52 at the bonding surface, at which the Si phase comes into contact with the metal layer 13 (Cu layer 13B), is sufficiently made to be fine, and diffusion of Cu in the metal layer 13 (Cu layer 13B) is not promoted in the subsequent metal layer/heat sink bonding step S05. Accordingly, it is possible to suppress occurrence of a Kirkendall void at a bonding interface.

Here, in a case where D90 of the equivalent circle diameter of the Si phase 52 dispersed in the parent phase is less than 1 µm, the vicinity of the bonding surface of the heat sink 31 is hardened more than necessary due to precipitation hardening by a finely dispersed Si phase, and thus there is a concern that cracking may occur in the ceramic substrate 11 due to a thermal stress that occurs when a heat cycle is applied to the power module substrate with a heat sink 30.

On the other hand, in a case where D90 of the equivalent circle diameter of the Si phase 52 dispersed in the parent phase is greater than 8 µm, diffusion of Cu is promoted, and thus there is a concern that it is difficult to sufficiently suppress occurrence of the Kirkendall void at the bonding interface.

Accordingly, in this embodiment, D90 of the equivalent circle diameter of the Si phase 52 at the bonding surface is set in a range of 1 µm to 8 µm.

Furthermore, it is preferable that D50 of the equivalent circle diameter of the Si phase 52 be 5 µm or less so as to reliably suppress occurrence of the Kirkendall void at the bonding interface, and it is more preferable that D50 of the equivalent circle diameter of the Si phase 52 be 3 µm or less and D90 be 6 µm or less.

In addition, since the heat sink 31 is constituted by an aluminum alloy in which the Si concentration is set in a range of 1 mass% to 25 mass%, it is possible to construct the heat sink 31 having a complicated structure provided with the flow passage 32, and thus it is possible to improve heat dissipation characteristics of the heat sink 31.

In addition, since occurrence of the Kirkendall void at the bonding interface is suppressed, it is possible to construct the high-performance power module substrate with a heat sink 30 in which the bonding strength between the heat sink 31 and the metal layer 13 (Cu layer 13B) is excellent, and heat resistance is small.

In addition, in this embodiment, when performing the solid-phase diffusion bonding, in a case where scratches exist on the bonding surfaces, there is a concern that a gap may occur at the bonding interface. However, in this embodiment, the bonding surfaces of the Cu layer 13B (copper plate 23B) and the heat sink 31 are subjected to the solid-phase diffusion bonding after scratches on the surfaces are removed in advance and the surfaces are made to be smooth. Accordingly, it is possible to suppress occurrence of the gap at the bonding interface, and thus it is possible to reliably perform the solid-phase diffusion bonding.

In addition, in this embodiment, the intermetallic compound layer, which is formed from an intermetallic compound of Cu and Al, is formed at the bonding interface between the metal layer 13 (Cu layer 13B) and the heat sink 31, and the intermetallic compound layer has a structure in which a plurality of the intermetallic compounds are laminated along the bonding interface. Accordingly, it is possible to suppress excessive growth of the intermetallic compounds which are brittle. In addition, a volume variation on an inner side of the intermetallic compound layer decreases, and thus an internal strain is suppressed.

In addition, in this embodiment, at the bonding interface between the Cu layer 13B and the intermetallic compound layer, oxides are dispersed in a layer shape along the bonding interface. Accordingly, an oxide film formed at the bonding surface of the heat sink 31 is reliably broken, and mutual diffusion of Cu and Al sufficiently progresses, and thus the Cu layer 13B and the heat sink 31 are reliably bonded to each other.

### (Second Embodiment)

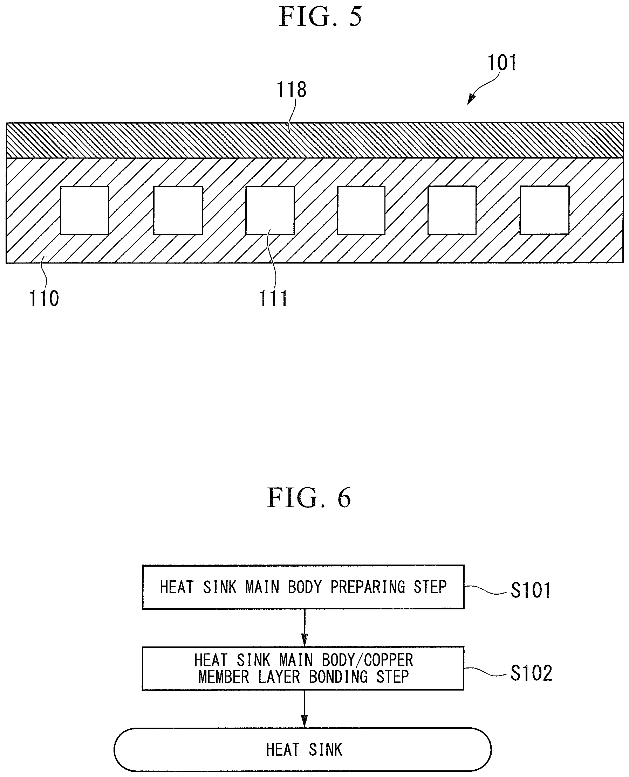

Next, description will be given of a heat sink according to a second embodiment of the invention. FIG. 5 illustrates a heat sink 101 according to the second embodiment of the invention.

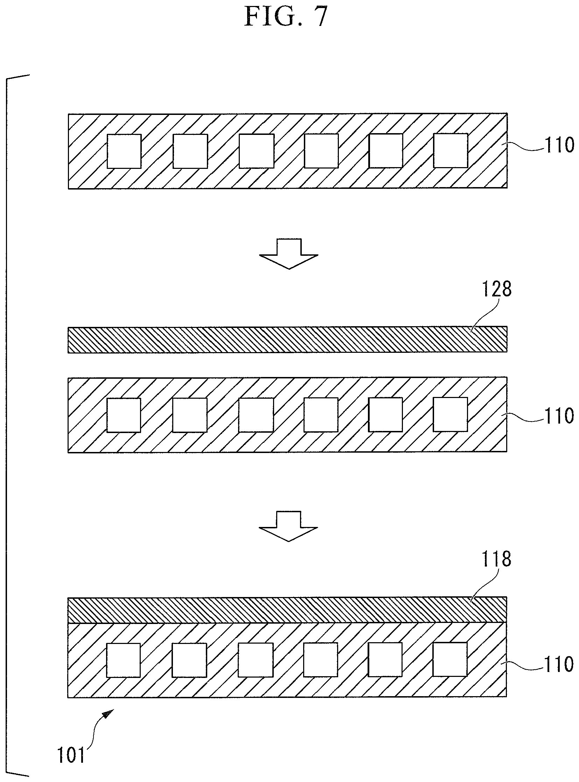

The heat sink 101 includes a heat sink main body 110, and a copper member layer 118 that is laminated on a surface on one side (upper side in FIG. 5) of the heat sink main body 110 and is formed from copper or a copper alloy. In this embodiment, as illustrated in FIG. 7, the copper member layer 118 is constituted through bonding of a copper plate 128 constituted by a rolled plate of oxygen-free copper.

The heat sink main body 110 is provided with a flow passage 111 through which a cooling medium flows. The heat sink main body 110 is constituted by an aluminum alloy in which a Si concentration is set in a range of 1 mass% to 25 mass%. Specifically, the heat sink main body 110 is constituted by ADC3 that is a die-casting aluminum alloy defined in JIS H 2118:2006. Furthermore, ADC3 is an aluminum alloy that contains Si in a range of 9.0 to 11.0 mass%, and Mg in a range of 0.45 to 0.64 mass%. The Si concentration of the aluminum alloy is preferably set in a range of 10.5 mass% to 11.0 mass%, but there is no limitation to this range.

Here, the heat sink main body 110 and the copper member layer 118 are subjected to solid-phase diffusion bonding.

An intermetallic compound layer is formed at a bonding interface between the heat sink main body 110 and the copper member layer 118. The intermetallic compound layer is formed through mutual diffusion of Al atoms of the heat sink main body 110 and Cu atoms of the copper member layer 118. The intermetallic compound layer has a concentration gradient in which the concentration of Al atoms further decreases, and the concentration of Cu atoms further increases as it goes toward the copper member layer 118 from the heat sink main body 110.

The intermetallic compound layer is constituted by an intermetallic compound composed of Cu and Al. In this embodiment, the intermetallic compound layer has a structure in which a plurality of the intermetallic compounds are laminated along the bonding interface. Here, the thickness of the intermetallic compound layer is set in a range of 1 µm to 80 µm, and preferably in a range of 5 µm to 80 µm.

In addition, in this embodiment, the intermetallic compound layer has a structure in which three kinds of intermetallic compounds are laminated. In the order from the heat sink main body 110 side toward the copper member layer 118 side, a θ-phase and a η₂-phase are laminated along the bonding interface between the heat sink main body 110 and the copper member layer 118, and at least one phase among a ζ₂-phase, a δ-phase, and a γ₂-phase is additionally laminated.

In addition, at the bonding interface between the intermetallic compound layer and the copper member layer 118, oxides are dispersed in a layer shape along the bonding interface. Furthermore, in this embodiment, the oxides are composed of aluminum oxides such as alumina (Al₂O₃). In addition, the oxides are dispersed at the interface between the intermetallic compound layer and the copper member layer 118 in a disconnected state, and a region, in which the intermetallic compound layer and the copper member layer 118 are in direct contact with each other, also exists. In addition, the oxides may be dispersed at the inside of the θ-phase, the η₂-phase, and at least one phase among the ζ₂-phase, the δ-phase, and the γ₂-phase in a layer shape.

Next, description will be given of a method of manufacturing the heat sink 101 according to this embodiment with reference to FIG. 6 and FIG. 7.

### (Heat Sink Main Body Preparing Step S101)

First, the heat sink main body 110 to be bonded is prepared. At this time, as is the case with the heat sink 31 (refer to FIG. 4) described in the first embodiment, at a bonding surface with the copper member layer 118 in the heat sink main body 110, D90 of the equivalent circle diameter of the Si phase dispersed in the parent phase is set in a range of 1 µm to 8 µm.

Here, when casting the heat sink main body 110, it is possible to control a size and a shape of the Si phase at the bonding surface by adjusting a cooling rate at least in the vicinity of the bonding surface of the heat sink main body 110. In this case, for example, a mold temperature in the casting may be set to 230°C or lower, and preferably 210°C or lower. The lower limit of the mold temperature during the casting may be 170°C, but there is no limitation thereto.

Alternatively, it is possible to control the size and the shape of the Si phase at the bonding surface by melting at least the vicinity of the bonding surface of the heat sink main body 110 and rapidly cooling the vicinity.

### (Heat Sink Main Body/Copper Member Layer Bonding Step S102)

Next, as illustrated in FIG. 7, the heat sink main body 110 and a copper plate 128 that becomes the copper member layer 118 are laminated, and the resultant laminated body is put in a vacuum heating furnace and is heated therein in a pressurized state (pressure is set to 1 to 35 kgf/cm² (0.10 to 3.43 MPa)) in a laminating direction to subject the copper plate 128 and the heat sink main body 110 to the solid-phase diffusion bonding. Furthermore, in respective bonding surfaces, which are subjected to the solid-phase diffusion bonding, of the copper plate 128 and the heat sink main body 110, scratches on the bonding surface are removed in advance and thus the bonding surfaces are made to be smooth.

Here, it is preferable that the pressure inside the vacuum heating furnace be set in a range of 10⁻⁶ Pa to 10⁻³ Pa, a heating temperature be set to 400°C to 520°C, and retention time be set in a range of 0.5 hours to 3 hours.

In this manner, the heat sink 101 according to this embodiment is manufactured.

According to the method of manufacturing the heat sink 101, which has the above-described configuration, according to this embodiment, the heat sink main body 110 constituted by an aluminum alloy, in which the Si concentration is set in a range of 1 mass% to 25 mass%, is used, and the method includes the heat sink main body preparing step S101 of preparing the heat sink main body 110 in which at the bonding surface with the copper member layer 118 (copper plate 128), D90 of the equivalent circle diameter of the Si phase dispersed in the parent phase is set in a range of 1 µm to 8 µm. Accordingly, the Si phase at the bonding surface, at which the Si phase comes into contact with the copper member layer 118 (copper plate 128), is sufficiently made to be fine, and diffusion of Cu in the copper member layer 118 (copper plate 128) is not promoted. Accordingly, it is possible to suppress occurrence of a Kirkendall void at a bonding interface.

In addition, in this embodiment, the copper member layer 118 is formed by bonding the copper plate 128 constituted by a rolled plate of oxygen-free copper on one surface of the heat sink main body 110, and thus it is possible to make heat spread in a plane direction by the copper member layer 118, and thus it is possible to greatly improve heat dissipation characteristics. In addition, it is possible to bond another member and the heat sink 101 by using solder and the like in a satisfactory manner.

In addition, the heat sink main body 110 is constituted by an aluminum alloy in which the Si concentration is set in a range of 1 mass% to 25 mass%. Specifically, the heat sink main body 110 is constituted by ADC3 (Si concentration is 9.0 to 11.0 mass%) that is a die-casting aluminum alloy defined in JIS H 2118:2006. Accordingly, it is possible to construct the heat sink main body 110 having a complicated structure provided with a flow passage and the like.

In addition, in this embodiment, since the bonding interface between the copper member layer 118 and the heat sink main body 110 has the same configuration as that of the bonding interface between the Cu layer 13B and the heat sink 31 according to the first embodiment, it is possible to exhibit the same operational effect as in the first embodiment.

Hereinbefore, description has been given of the embodiments of the invention.

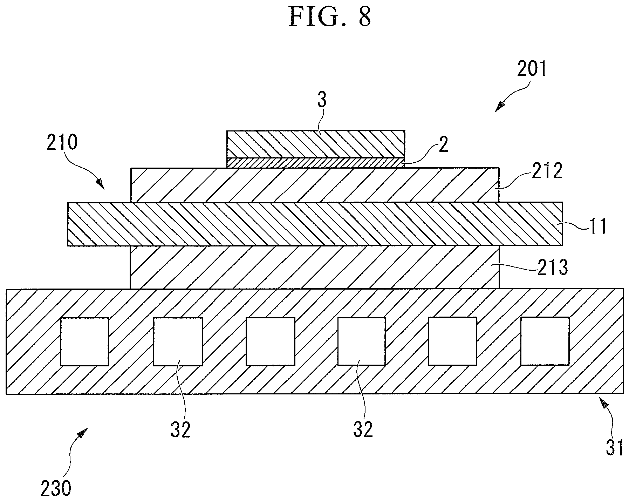

For example, in the first embodiment, description has been given of a configuration in which the metal layer 13 includes the Al layer 13A and the Cu layer 13B, but there is no limitation thereto. As illustrated in FIG. 8, the entirety of the metal layer may be constituted by copper or a copper alloy. In a power module substrate with a heat sink 230 illustrated in FIG. 8, a copper plate is bonded to a surface on the other side (lower side in FIG. 8) of the ceramic substrate 11 in accordance with a DBC method, an active metal brazing method, and the like, and a metal layer 213 formed from copper or a copper alloy is formed. In addition, the metal layer 213 and the heat sink 31 are subjected to the solid-phase diffusion bonding. Furthermore, in the power module substrate 210 illustrated in FIG. 8, a circuit layer 212 is also constituted by copper or a copper alloy.

In addition, in the first embodiment, description has been given of a configuration in which the circuit layer is formed through bonding of an aluminum plate having the purity of 99 mass% or greater, but there is no limitation thereto. The circuit layer may be constituted by other metals such as aluminum (4N-Al) having the purity of 99.99 mass% or greater, another aluminum or aluminum alloy, and copper or a copper alloy. In addition, the circuit layer may be set to have a two-layer structure of an Al layer and a Cu layer. This is also true of the power module substrate with a heat sink illustrated in FIG. 8.

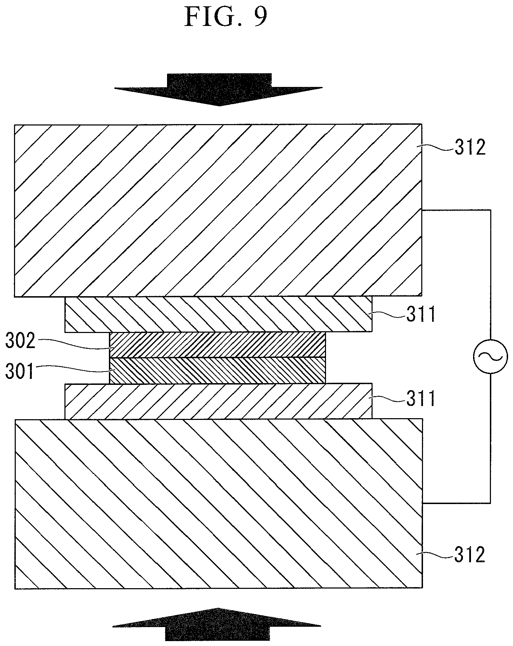

In addition, in the metal layer/heat sink bonding step S05 according to the first embodiment, description has been given of a configuration in which the metal layer 13 (Cu layer 13B) and the heat sink 31 are laminated, and the resultant laminated body is put in a vacuum heating furnace and is heated therein in a pressurized state in a laminating direction. In addition, in the heat sink main body/copper member layer bonding step S102 according to the second embodiment, description has been given of a configuration in which the heat sink main body 110 and the copper plate 128 that becomes the copper member layer 118 are laminated, and the resultant laminated body is put in a vacuum heating furnace and is heated therein in a pressurized state (pressure of 5 to 35 kgf/cm²) in a laminating direction. However, there is no limitation to the above-described configurations, and as illustrated in FIG. 9, an electrical heating method may be applied when subjecting an aluminum member 301 (the heat sink 31, the heat sink main body 110), and a copper member 302 (the metal layer 13, the copper member layer 118) to the solid-phase diffusion bonding.

In a case of performing the electrical heating, as illustrated in FIG. 9, the aluminum member 301 and the copper member 302 are laminated, and the resultant laminated body is pressurized in a laminating direction by a pair of electrodes 312 and 312 through carbon plates 311 and 311, and electrification is performed with respect to the aluminum member 301 and the copper member 302. In this case, the carbon plates 311 and 311, the aluminum member 301, and the copper member 302 are heated by Joule's heat, and thus the aluminum member 301 and the copper member 302 are subjected to the solid-phase diffusion bonding.

In the above-described electrical heating method, the aluminum member 301 and the copper member 302 are directly electrically heated. Accordingly, for example, it is possible to make a temperature rising rate be as relatively fast as 30 to 100°C/min, and thus it is possible to perform the solid-phase diffusion bonding in a short time. As a result, an influence of oxidation on a bonding surface is small, and thus it is possible to perform bonding, for example, in an atmospheric atmosphere. In addition, in accordance with a resistance value or specific heat of the aluminum member 301 and the copper member 302, it is possible to bond the aluminum member 301 and the copper member 302 in a state in which a temperature difference occurs therebetween, and thus a difference in thermal expansion decreases. As a result, it is possible to realize a reduction in a thermal stress.

Here, in the above-described electrical heating method, it is preferable that a pressurizing load that is applied by the pair of electrodes 312 and 312 be set in a range of 30 kgf/cm² to 100 kgf/cm² (2.94 MPa to 9.8 MPa).

In addition, in a case of applying the electrical heating method, with regard to surface roughness of the aluminum member 301 and the copper member 302, it is preferable that arithmetic average roughness Ra be set to 0.3 µm to 0.6 µm, and the maximum height Rz be set in a range of 1.3 µm to 2.3 µm. In typical solid-phase diffusion bonding, it is preferable that the surface roughness of the bonding surface be small. However, in a case of the electrical heating method, when the surface roughness of the bonding surface is too small, interface contact resistance decreases, and thus it is difficult to locally heat the bonding interface. Accordingly, the surface roughness is preferably set in the above-described range.

Furthermore, the above-described electrical heating method can be used in the metal layer/heat sink bonding step S05 according to the first embodiment. In this case, since the ceramic substrate 11 is an insulator, it is necessary to short-circuit the carbon plates 31 1 and 311, for example, with a jig formed from carbon, and the like. Bonding conditions are the same as those in the bonding between the aluminum member 301 and the copper member 302.

In addition, surface roughness of the metal layer 13 (Cu layer 13B) and the heat sink 31 is the same as in the case of the aluminum member 301 and the copper member 302.

### EXAMPLES

Hereinafter, description will be given of results of a confirmation experiment that is performed to confirm the effect of the invention.

### (Preparation of Test Piece)

A copper plate (2 mm×2 mm, thickness: 0.3 mm) formed from oxygen-free copper was bonded to one surface of an aluminum plate illustrated in Table 1 (10 mm×10 mm, thickness: 3 mm) through the solid-phase diffusion bonding in accordance with the method described in the above-described embodiment.

In Examples 1 to 7, and Comparative Examples 1 and 2, the aluminum plate and the copper plate were pressurized in a laminating direction with a load of 15 kgf/cm² (1.47 MPa), and were subjected to the solid-phase diffusion bonding in a vacuum heating furnace under conditions of 500°C for 120 minutes.

In Examples 8 to 11, the aluminum plate and the copper plate were subjected to the solid-phase diffusion bonding accordance with the electrical heating method illustrated in FIG. 9. Furthermore, in the electrodes, a pressurizing load was set to 15 kgf/cm² (1.47 MPa), a heating temperature (copper plate temperature) was set to 510°C, retention time at the heating temperature was set to 5 minutes, and a temperature rising rate was set to 80 °C/minute. In addition, a bonding atmosphere was set to an atmospheric atmosphere.

### (Grain Size of Si phase at Bonding Surface)

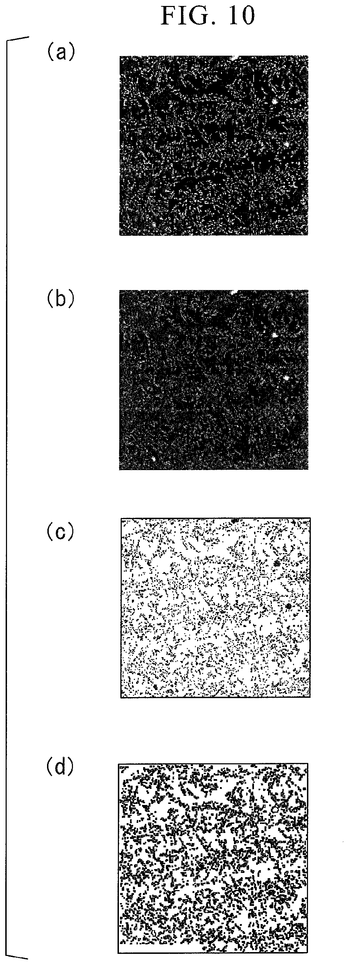

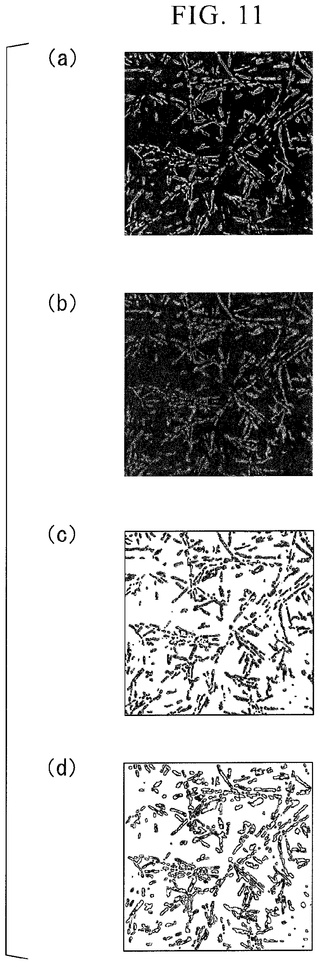

Before bonding, a structure observation was performed with respect to a bonding surface of the aluminum plate to measure D90 and D50 of the Si phase dispersed in the parent phase as follows. Furthermore, FIG. 10 illustrates a measurement example of Example 2, and FIG. 11 illustrates a measurement example of Comparative Example 2.

First, surface analysis of Si was performed by using EPMA (JXA-8530F, manufactured by JEOL Ltd.) under conditions of a visual field of 360 µm, an acceleration voltage of 15 kV, and a Si contour level of 0 to 1000, thereby obtaining a Si distribution image illustrated in FIG. 10(a) and FIG. 11(a).

The obtained Si distribution image was converted into an 8-bit gray scale, thereby obtaining a Si distribution image illustrated in FIG. 10(b) and FIG. 11(b).

Next, the Si distribution image was binarized as illustrated in FIG. 10(c) and FIG. 11(c) on the basis of Kapur-Sahoo-Wong (Maximum Entropy) thresholding method (Kapur, JN; Sahoo, PK; Wong, ACK(1985), "A New Method for Gray-Le v el Picture Thresholding Using the Entropy of the Histogram", Graphical Models and Image Processing 29(3): refer to 273-285).

Next, as illustrated in FIG. 10(d) and FIG. 11(d), a contour of the Si phase was extracted from the binarized image.

An equivalent circle diameter (diameter) was calculated from an area (the number of pixels) in the contour on the basis of the image from which the contour of the Si phase was extracted.

In addition, D90 and D50 of the equivalent circle diameter that was calculated were obtained. Measurement results are illustrated in Table 1.

### (Shear Test)

A shear test was performed by using the test piece. Furthermore, the shear test was performed on the basis of standard IEC60749-19 of International Electrotechnical Commission. An n number in the shear test was set to 30. In a Weibull plot of shear strength, an accumulative failure rate at which the shear strength becomes 100 MPa was set as a breakage rate. Furthermore, calculation of the accumulative failure rate was performed on the basis of a median rank. Evaluation results are illustrated in Table 1.

### (Evaluation of Ceramic Cracking)

In addition, the power module substrate with a heat sink having a structure described in the first embodiment was prepared by setting the aluminum plate illustrated in Table 1 as the heat sink. The configuration of the power module substrate with a heat sink is as follows. Furthermore, the solid-phase diffusion bonding between the metal layer (Cu layer) and the heat sink was performed with a vacuum heating furnace under conditions of 500°C for 120 minutes in a state in which a load in the laminating direction was set to 15 kgf/cm² (1.47 MPa).
Ceramic substrate: AlN, 40 mm×40 mm, thickness: 0.635 mm
Circuit layer: 4N aluminum, 37 mm×37 mm, thickness: 0.6 mm
Metal layer (Al layer): 4N aluminum, 37 mm×37 mm, thickness: 0.9 mm
Metal layer (Cu layer): Oxygen-free copper, 37 mm×37 mm, thickness: 0.3 mm
Heat sink: aluminum alloy described in Table 1, 50 mm×50 mm, thickness: 5 mm

A thermal cycle for 5 minutes at -40°C and for 5 minutes at 150°C was applied to the power module substrate with a heat sink 2500 times by using a cold impact tester (TSB-51, manufactured by ESPEC CORP.) in a liquid phase (Fluorinert), and presence or absence of cracking in the ceramic substrate was evaluated by using an ultrasonic testing device. Evaluation results are illustrated in Table 1.

**[Table 1]**

| | Aluminum plate | | Equivalent circle diameter of Si phase at bonding surface | | Shear test | Cold-hot cycle |
|---|---|---|---|---|---|---|
| | Material | Si concentration (mass%) | D90 (µm) | D50 (µm) | Breakage rate (ppm) | Cracking in ceramic substrate |
| Example 1 | ADC12 | 11.6 | 1.2 | 0.7 | 5 | Absent |
| Example 2 | ADC12 | 10.2 | 2.7 | 1.1 | 12 | Absent |
| Example 3 | ADC12 | 11.6 | 5.2 | 2.6 | 65 | Absent |
| Example 4 | ADC12 | 11.8 | 6.4 | 2.8 | 163 | Absent |
| Example 5 | ADC12 | 10.5 | 7.5 | 4.6 | 274 | Absent |
| Example 6 | AC9C | 23.9 | 4.0 | 1.0 | 32 | Absent |
| Example 7 | ADC6 | 1.0 | 4.0 | 1.1 | 26 | Absent |
| Example 8 | ADC12 | 11.4 | 1.3 | 0.8 | 7 | Absent |
| Example 9 | ADC12 | 10.5 | 7.4 | 4.8 | 248 | Absent |
| Example 10 | AC9C | 23.7 | 3.6 | 1.2 | 22 | Absent |
| Example 11 | ADC6 | 1.0 | 4.1 | 1.2 | 49 | Absent |
| Comparative Example 1 | ADC12 | 12.0 | 0.2 | 0.05 | 4 | Present |
| Comparative Example 2 | ADCl2 | 11.8 | 15 | 7.4 | 841 | Absent |

In Comparative Example 1 in which D90 of the Si phase at the bonding surface of the aluminum plate (heat sink) is smaller than a range of the invention, cracking occurred in the ceramic substrate. The reason for this is assumed to be because numerous fine Si particles were dispersed and thus the aluminum plate (heat sink) was hardened more than necessary.

In Comparative Example 2 in which D90 of the Si phase at the bonding surface of the aluminum plate (heat sink) is greater than the range of the invention, the failure rate through the shear test was very high. The reason for this is assumed to be because numerous Kirkendall voids occurred at the bonding interface.

In contrast, in Examples 1 to 11 in which D90 of the Si phase at the bonding surface of the aluminum plate (heat sink) is set in the range of the invention, the breakage rate was relatively low, and occurrence of the ceramic cracking was not confirmed. In addition, in Example 6 in which the Si concentration was set to 23.9 mass%, and Example 7 in which the Si concentration was set to 1.0 mass%, the same results were obtained. In addition, in Examples 8 to 11 to which the electrical heating method was applied, even when bonding was performed in the atmosphere, the aluminum plate and the copper plate were bonded to each other in a satisfactory manner.

From the above-described results, according to the examples, it was confirmed that it is possible to manufacture a bonded body in which the aluminum member formed from an aluminum alloy that contains a relatively large amount of Si, and the copper member formed from copper or a copper alloy are bonded to each other in a satisfactory manner.

### INDUSTRIAL APPLICABILITY

According to the method of manufacturing the bonded body of the invention, it is possible to suppress occurrence of a Kirkendall void at the bonding interface between the aluminum member and the copper member. In addition, according to the method of manufacturing the power module substrate with a heat sink of the invention, it is possible to provide a power module substrate with a heat sink in which heat resistance is small and heat dissipation is excellent.

### REFERENCE SIGNS LIST

10, 210: Power module substrate
11: Ceramic substrate
13, 213: Metal layer
13B: Cu layer (copper member)
30, 230: Power module substrate with heat sink
31: Heat sink (aluminum member)
52: Si phase
101: Heat sink
110: Heat sink main body
118: Copper member layer

## Claims

1. A method of manufacturing a bonded body in which a copper member formed from copper or a copper alloy, and an aluminum member formed from an aluminum alloy in which a Si concentration is set in a range of 1 mass% to 25 mass% are bonded to each other,
wherein in the aluminum member before the bonding, D90 of an equivalent circle diameter of a Si phase at a bonding surface with the copper member is set in a range of 1 µm to 8 µm, and
the aluminum member and the copper member are subjected to solid-phase diffusion bonding.

2. The method of manufacturing a bonded body according to Claim 1,
wherein the aluminum member and the copper member are laminated and are electrically heated while being pressurized in a laminating direction to subject the aluminum member and the copper member to the solid-phase diffusion bonding.

3. A method of manufacturing a power module substrate with a heat sink, the substrate including an insulating layer, a circuit layer that is formed on one surface of the insulating layer, a metal layer that is formed on the other surface of the insulating layer, and a heat sink that is disposed on a surface of the metal layer which is opposite to the insulating layer,
wherein a bonding surface with the heat sink in the metal layer is constituted by copper or a copper alloy,
a bonding surface with the metal layer in the heat sink is constituted by an aluminum alloy in which a Si concentration is set in a range of 1 mass% to 25 mass%,
in the heat sink before the bonding, D90 of an equivalent circle diameter of a Si phase at the bonding surface with the metal layer is set in a range of 1 µm to 8 µm, and
the heat sink and the metal layer are subjected to solid-phase diffusion bonding.

4. The method of manufacturing a power module substrate with a heat sink according to Claim 3,
wherein the heat sink and the metal layer are laminated and are electrically heated while being pressurized in a laminating direction to subject the heat sink and the metal layer to the solid-phase diffusion bonding.

5. A method of manufacturing a heat sink including a heat sink main body, and a copper member layer formed from copper or a copper alloy,
wherein the heat sink main body is constituted by an aluminum alloy in which a Si concentration is set in a range of 1 mass% to 25 mass%,
in the heat sink main body before the bonding, D90 of an equivalent circle diameter of a Si phase at a bonding surface with the copper member layer is set in a range of 1 µm to 8 µm, and
the heat sink main body and the copper member layer are subjected to solid-phase diffusion bonding.

6. The method of manufacturing a heat sink according to Claim 5,
wherein the heat sink main body and the copper member layer are laminated and are electrically heated while being pressurized in a laminating direction to subject the heat sink main body and the copper member layer to the solid-phase diffusion bonding.

## Patentansprüche

1. Verfahren zur Herstellung eines Verbundkörpers, in dem ein Kupferteil, das aus Kupfer oder einer Kupferlegierung gebildet ist, und ein Aluminiumteil, das aus einer Aluminiumlegierung gebildet ist, in der eine Si-Konzentration in einem Bereich von 1 Masse-% bis 25 Masse-% eingestellt ist, aneinander gebunden werden,
wobei in dem Aluminiumteil vor dem Verbinden ein äquivalenter Kreisdurchmesser D90 einer Si-Phase an einer Bindungsoberfläche mit dem Kupferteil in einem Bereich von 1 µm bis 8 µm eingestellt ist und
das Aluminiumteil und das Kupferteil einem Festkörperdiffusionsverbindungsvorgang unterzogen werden.

2. Verfahren zur Herstellung eines Verbundkörpers gemäß Anspruch 1,
worin das Aluminiumteil und das Kupferteil laminiert werden und elektrisch erwärmt werden, während sie in einer Laminierungsrichtung unter Druck gesetzt werden, um das Aluminiumteil und das Kupferteil dem Festkörperdiffusionsverbindungsvorgang zu unterziehen.

3. Verfahren zur Herstellung eines Leistungsmodulsubstrats mit einem Kühlkörper, wobei das Substrat eine Isolierschicht, eine Schaltkreisschicht, die auf einer Oberfläche der Isolierschicht gebildet ist, eine Metallschicht, die auf der anderen Oberfläche der Isolierschicht gebildet ist, und einen Kühlkörper, der sich auf einer Oberfläche der Metallschicht, die der Isolierschicht gegenübersteht, angeordnet ist,
wobei eine Bindungsoberfläche mit dem Kühlkörper in der Metallschicht aus Kupfer oder einer Kupferlegierung gebildet ist,
eine Bindungsoberfläche zwischen der Metallschicht und dem Kühlkörper durch eine Aluminiumlegierung, in der eine Si-Konzentration in einem Bereich von 1 Masse-% bis 25 Masse-% eingestellt ist, gebildet ist,
in dem Kühlkörper vor dem Verbinden ein äquivalenter Kreisdurchmesser D90 einer Si-Phase an der Bindungsoberfläche mit der Metallschicht in einem Bereich von 1 µm bis 8 µm eingestellt ist und
der Kühlkörper und die Metallschicht einem Festkörperdiffusionsverbindungsvorgang unterzogen werden.

4. Verfahren zur Herstellung eines Leistungsmodulsubstrats mit einem Kühlkörper gemäß Anspruch 3,
wobei der Kühlkörper und die Metallschicht laminiert werden und elektrisch erwärmt werden, während sie in einer Laminierungsrichtung unter Druck gesetzt werden, um den Kühlkörper und die Metallschicht einem Festkörperdiffusionsverbindungsvorgang zu unterziehen.

5. Verfahren zur Herstellung eines Kühlkörpers, der einen Kühlkörperhauptkörper und eine Kupferteilschicht, die aus Kupfer oder einer Kupferlegierung gebildet ist, einschließt,
wobei der Kühlkörperhauptkörper aus einer Aluminiumlegierung gebildet ist, in der eine Si-Konzentration in einem Bereich von 1 Masse-% bis 25 Masse-% eingestellt ist,
in dem Kühlkörperhauptkörper vor dem Verbinden ein äquivalenter Kreisdurchmesser D90 einer Si-Phase an der Bindungsoberfläche mit der Kupferteilschicht in einem Bereich von 1 µm bis 8 µm eingestellt ist und
der Kühlkörperhauptkörper und die Kupferteilschicht einem Festkörperdiffusionsverbindungsvorgang unterzogen werden.

6. Verfahren zur Herstellung eines Kühlkörpers gemäß Anspruch 5,
worin der Kühlkörperhauptkörper und die Kupferteilschicht laminiert werden und elektrisch erwärmt werden, während sie in einer Laminierungsrichtung unter Druck gesetzt werden, um den Kühlkörperhauptkörper und die Kupferteilschicht einem Festkörperdiffusionsverbindungsvorgang zu unterziehen.

## Revendications

1. Procédé de fabrication d'un corps lié dans lequel un élément de cuivre formé d'un cuivre ou d'un alliage de cuivre, et un élément d'aluminium formé d'un alliage d'aluminium dans lequel une concentration en Si est définie dans une plage de 1 % en masse à 25 % en masse sont liés l'un à l'autre,
dans lequel dans l'élément d'aluminium avant la liaison, un diamètre équivalent circulaire D90 d'une phase de Si au niveau d'une surface de liaison avec l'élément de cuivre est défini dans une plage de 1 µm à 8 µm, et
l'élément d'aluminium et l'élément de cuivre sont soumis à la liaison par diffusion en phase solide.

2. Procédé de fabrication d'un corps lié selon la revendication 1,
dans lequel l'élément d'aluminium et l'élément de cuivre sont laminés et sont chauffés électriquement tout en étant pressurisés dans une direction de laminage pour soumettre l'élément d'aluminium et l'élément de cuivre à la liaison par diffusion en phase solide.

3. Procédé de fabrication d'un substrat de module de puissance avec un dissipateur de chaleur, le substrat incluant une couche isolante, une couche de circuit qui est formée sur une surface de la couche isolante, une couche métallique qui est formée sur l'autre surface de la couche isolante, et un dissipateur de chaleur qui est disposé sur une surface de la couche métallique qui est opposée à la couche isolante,
dans lequel une surface de liaison avec le dissipateur de chaleur dans la couche métallique est constituée par du cuivre ou un alliage de cuivre,
une surface de liaison avec la couche métallique dans le dissipateur de chaleur est constituée par un alliage d'aluminium dans lequel une concentration en Si est définie dans une plage de 1 % en masse à 25 % en masse,
dans le dissipateur de chaleur avant la liaison, un diamètre équivalent circulaire D90 d'une phase de Si au niveau de la surface de liaison avec la couche métallique est défini dans une plage de 1 µm à 8 µm, et
le dissipateur de chaleur et la couche métallique sont soumis à la liaison par diffusion en phase solide.

4. Procédé de fabrication d'un substrat de module de puissance avec un dissipateur de chaleur selon la revendication 3,
dans lequel le dissipateur de chaleur et la couche métallique sont laminés et sont chauffés électriquement tout en étant pressurisés dans une direction de laminage pour soumettre le dissipateur de chaleur et la couche métallique à la liaison par diffusion en phase solide.

5. Procédé de fabrication d'un dissipateur de chaleur incluant un corps principal de dissipateur de chaleur, et une couche d'élément de cuivre formée de cuivre ou d'un alliage de cuivre,
dans lequel le corps principal de dissipateur de chaleur est constitué par un alliage d'aluminium dans lequel une concentration en Si est définie dans une plage de 1 % en masse à 25 % en masse,
dans le corps principal de dissipateur de chaleur avant la liaison, un diamètre équivalent circulaire D90 d'une phase de Si au niveau d'une surface de liaison avec la couche d'élément de cuivre est définie dans une plage de 1 µm à 8 µm, et
le corps principal de dissipateur de chaleur et la couche d'élément de cuivre sont soumis à la liaison par diffusion en phase solide.

6. Procédé de fabrication d'un dissipateur de chaleur selon la revendication 5,
dans lequel le corps principal de dissipateur de chaleur et la couche d'élément de cuivre sont laminés et sont chauffés électriquement tout en étant pressurisés dans une direction de laminage pour soumettre le corps principal de dissipateur de chaleur et la couche d'élément de cuivre à la liaison par diffusion en phase solide.
